# EUROPÄISCHE PATENTSCHRIFT

(11) **EP 0 762 450 B1**
(45) Veröffentlichungstag und Bekanntmachung des Hinweises auf die Patenterteilung: **29.09.1999**
(21) Anmeldenummer: 96110338.9
(22) Anmeldetag: 27.06.1996
(51) Int. Cl.: H01H 9/50, H01H 1/00, G01R 31/327

(54) **Verfahren zur Überwachung eines Lastumschalters für einen Stufenschalter**
Method for monitoring an on-load switch for a tap changer
Procédé de surveillance d'un commutateur en charge pour un sélecteur de prises

(30) Priorität: 22.08.1995 DE 19530776
(43) Veröffentlichungstag der Anmeldung: 12.03.1997
(73) Patentinhaber: MASCHINENFABRIK REINHAUSEN GmbH, 93059 Regensburg (DE)
(72) Erfinder: Dohnal, Dieter, Dr.-Ing., 93138 Lappersdorf (DE)

(56) Entgegenhaltungen:
- EP-A- 0 482 547
- DE-A- 2 702 766
- DE-A- 4 316 239
- DE-A- 4 416 781
- GB-A- 2 158 253
- PATENT ABSTRACTS OF JAPAN vol. 010, no. 217 (E-423), 29.Juli 1986 & JP-A-61 054611 (TOSHIBA CORP), 18.März 1986,
- PATENT ABSTRACTS OF JAPAN vol. 010, no. 164 (E-410), 11.Juni 1986 & JP-A-61 018113 (MITSUBISHI DENKI KK), 27.Januar 1986,
- PATENT ABSTRACTS OF JAPAN vol. 010, no. 283 (E-440), 26.September 1986 & JP-A-61 102010 (TOSHIBA CORP), 20.Mai 1986,
- PATENT ABSTRACTS OF JAPAN vol. 012, no. 094 (E-593), 26.März 1988 & JP-A-62 226608 (TOSHIBA CORP), 5.Oktober 1987,

## Beschreibung

Die Erfindung betrifft ein Verfahren zur Überwachung eines Lastumschalters mit feststehenden Haupt- und Hilfskontakten und mit diesen korrespondierenden beweglichen Haupt- und Hilfskontakten, die sich nacheinander auf den jeweiligen feststehenden Kontakten abwälzen oder auf diesen abrollen und somit einen definierten Schaltablauf realisieren.

Ein solcher Lastumschalter, bei dem die feststehenden Haupt- und Hilfskontakte an der Innenwand einer Isolierstoffschale sektorförmig angeordnet sind und die beweglichen Kontakte auf einem drehbaren Schaltstern gemeinsam angeordnet sind, ist beispielsweise aus der DE-PS 19 30 719 bekannt.
Lastumschalter der beschriebenen Gattung sind zur Realisierung verschiedener Schaltungen und Schaltsequenzen geeignet.
Die Anwendung für eine sog. Fahnenschaltung ist aus der Druckschrift "Stufenschalter Typ M", Impressum Bro44/81de-0881/2500, der Anmelderin bekannt.
Die Anwendung für eine sog. Fahnen-Wimpel-Schaltung ist aus der weiteren Druckschrift "Stufenschalter Typ T", Impressum Bro84/81de-1281/2500 der Anmelderin ebenfalls bekannt. Bei diesen Lastumschaltern werden bei einer Umschaltung eine Reihe von Kontakten, bei der Fahnenschaltung üblicherweise 6, bei der Fahnen-Wimpel-Schaltung üblicherweise 8, jeweils einschließlich der Dauerhauptkontakte, in festgelegter Schaltsequenz durchlaufen. Die beteiligten Kontakte sind dabei einem ständigen Verschleiß, d.h. Kontaktabbrand, unterworfen.
Wird die Kontaktlebensdauer überschritten, d.h., ist ein unzulässig hoher Abbrand an einem oder mehreren der beteiligten Kontakte zu verzeichnen, so ergibt sich zwangsläufig eine Veränderung der jeweils ablaufenden Schaltsequenz, was zu Funktionsstörungen führt.
Dies umso mehr, als der Abbrand an den einzelnen Kontakten eines Lastumschalters nicht gleichmäßig an allen beteiligten Kontakten fortschreitet, sondern naturgemäß an den lichtbogenführenden Kontakten besonders ausgeprägt ist.
Die zu erwartende Kontaktlebensdauer der lichtbogenführenden Kontakte ist u.a. abhängig von der relativen Belastung Iu/Ium, wobei Iu der Durchgangsstrom und Ium der maximale Bemessung-Durchgangsstrom ist, hängt aber im Einzelfall von vielen Einflußfaktoren des betrieblichen Einsatzes ab, so daß sie nicht ohne weiteres aus der Zahl der absolvierten Schaltungen einfach abgeleitet oder sonstwie vorab zuverlässig bestimmt werden kann.

Aufgabe der Erfindung ist es, ein Verfahren zur Überwachung eines Lastumschalters der eingangs genannten Gattung anzugeben, das es gestattet, den zeitlichen Ablauf der Lastumschaltung, d.h. die Schaltsequenz, nach der die einzelnen Kontakte betätigt werden, zu überwachen und bei unzulässigen Abweichungen, die auf einen unzulässig hohen Abbrand an zumindest einem Kontakt oder auf eine andere Störung im Lastumschalter schließen lassen, eine Störungsmeldung zu generieren.

Diese Aufgabe wird erfindungsgemäß durch ein Verfahren mit den Merkmalen des Patentanspruchs 1 gelöst. Die Unteransprüche beinhalten Weiterbildungen des erfindungsgemäßen Verfahrens.

Das erfindungsgemäße Verfahren wertet die bei jeder Lastumschaltung auftretenden kurzen Lichtbögen hinsichtlich ihres zeitlichen Abstandes zueinander und nach einer besonderen Weiterbildung der Erfindung zusätzlich auch hinsichtlich ihrer Länge aus.
Ein erster Lichtbogen bei jeder Lastumschaltung tritt beim Öffnen des bisherigen Schaltkontaktes auf der abschaltenden Seite, der die Verbindung zur bisherigen Wicklungsanzapfung hergestellt hat, auf und erlischt normalerweise im ersten Nulldurchgang des Stromes.
Ein zweiter Lichtbogen tritt beim Öffnen des zugehörigen Widerstandskontaktes auf der abschaltenden Seite auf und erlischt wiederum normalerweise im nächsten Nulldurchgang des Stromes.
Sind weitere zugehörige Widerstandskontakte auf der abschaltenden Seite vorhanden, wie bei der weiter unten noch näher erläuterten Fahnen-Wimpel-Schaltung, treten bei deren Öffnen weitere Lichtbögen auf.

Das erfindungsgemäße Verfahren erkennt diese Lichtbögen und vergleicht das empfangene Lichtbogenmuster hinsichtlich des zeitlichen Mindestabstandes der Lichtbögen zueinander, d.h. der Zeit zwischen dem Verlöschen des vorhergehenden Lichtbogens und dem Zünden des nachfolgenden Lichtbogens, mit vorgegebenen Sollwerten.
Nach einer vorteilhaften Weiterbildung des erfindungsgemäßen Verfahrens wird weiterhin jeweils die Länge der einzelnen Lichtbögen erfaßt und ebenfalls mit voreingestellten Sollwerten verglichen.

Das erfindungsgemäße Verfahren und der Hintergrund der Erfindung sollen nachstehend noch näher erläutert werden.

Die Figuren zeigen:
- Fig. 1: den Ablauf eines ersten erfindungsgemäßen Verfahrens, bei dem beispielsweise die Lichtbogenerkennung durch Empfang der vom Lichtbogen erzeugten HF-Sequenz erfolgt
- Fig. 2: eine bekannte Fahnenschaltung und die entsprechende Schaltsequenz bei einem gattungsgemäßen Lastumschalter
- Fig. 3: das dazugehörige Oszillogramm der Lastumschaltung
- Fig. 4: eine detaillierte Schaltsequenz bei einer Lastumschaltung abwärts, wobei links jeweils die Schaltung, in der Mitte das Zeigerdiagramrn und rechts die mechanische Kontaktbewegung für jeden Schaltschritt dargestellt sind
- Fig. 5: eine ebenfalls bekannte Fahnen-Wimpel-Schaltung und die entsprechende Schaltsequenz bei einem gattungsgemäßen Lastumschalter
- Fig. 6: wiederum das dazugehörige Oszillogramm der Lastumschaltung bei dieser Schaltung
- Fig. 7: wiederum eine detaillierte Schaltsequenz dazu bei einer Lastumschaltung abwärts in gleicher Darstellung wie in Fig. 4
- Fig. 8: den Ablauf eines vorteilhaft weiterentwickelten zweiten erfindungsgemäßen Verfahrens, bei dem ebenfalls die Lichtbogenerkennung durch Empfang der vom Lichtbogen erzeugten HF-Sequenz erfolgt.

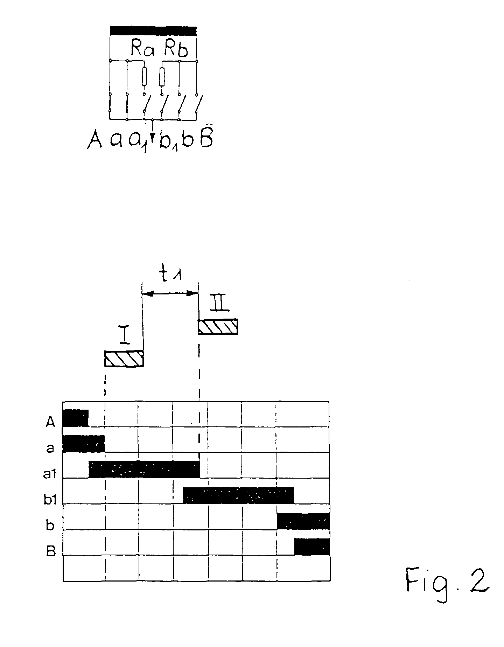

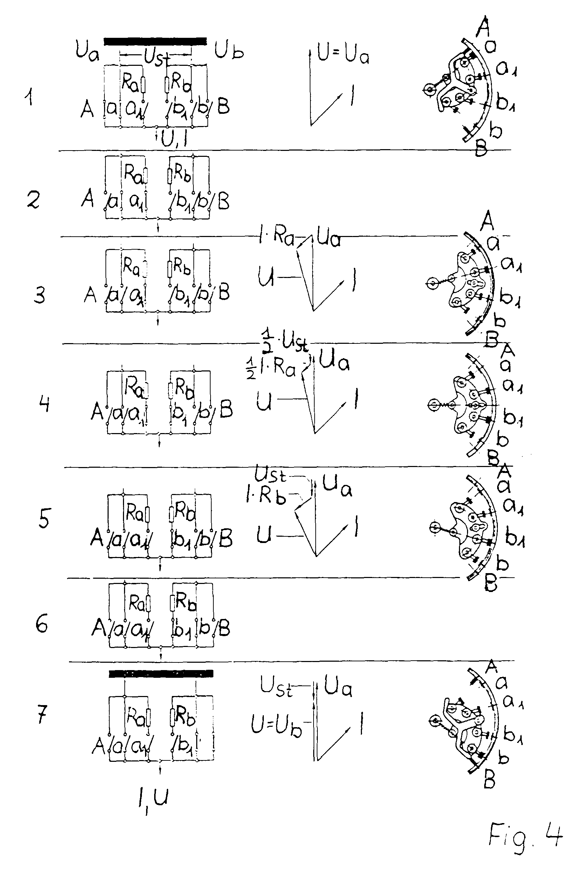

Fig. 2 zeigt eine bekannte Fahnenschaltung mit der dazugehörigen Schaltsequenz und zwei auftretenden Lichtbögen I und II; in Fig. 4 ist dazu gezeigt, daß der Lastumschalter bei jeder Umschaltung eine Sequenz von 7 Schaltstellungen durchläuft.
In den Darstellungen bedeuten:
- A,B: Hauptkontakte
- a,b: Schaltkontakte
- a1,b1: Widerstandskontakte
- Ra,Rb: Überschaltwiderstände
- Ua,Ub: Spannungen der Anzapfungen
- Ust: Stufenspannung
- U,I: Spannung u. Strom der Stufenschalterableitung.

Eine Lastableitung abwärts läuft wie folgt ab:
Stellung 1: der Hauptkontakt A ist geschlossen und führt den Betriebsstrom
Stellung 2: der Hauptkontakt A öffnet, Schaltkontakt a übernimmt den Betriebsstrom, Widerstandskontakt al wird geschlossen
Stellung 3: Schaltkontakt a öffnet, der auftretende Lichtbogen erlischt im ersten Nulldurchgang des Stromes, nach dem Löschen tritt über dem sich öffnenden Schaltkontakt a die Wiederkehrspannung auf; Widerstandskontakt a1 führt nun den Betriebsstrom
Stellung 4: Widerstandskontakt b1 schließt, der über beide Widerstandskontakte a1 und b1 fließende Kreisstrom wird durch die beiden in Reihe liegenden Überschaltwiderstände Ra und Rb begrenzt
Stellung 5: der Widerstandskontakt a1 öffnet, der Lichtbogen erlischt wiederum im nächsten Nulldurchgang des Stromes
Stellung 6: der Schaltkontakt b schließt und übernimmt den Betriebsstrom
Stellung 7: der Widerstandskontakt bl öffnet, der Hauptkontakt B schließt und übernimmt den Betriebsstrom; die Lastumschaltung ist beendet.

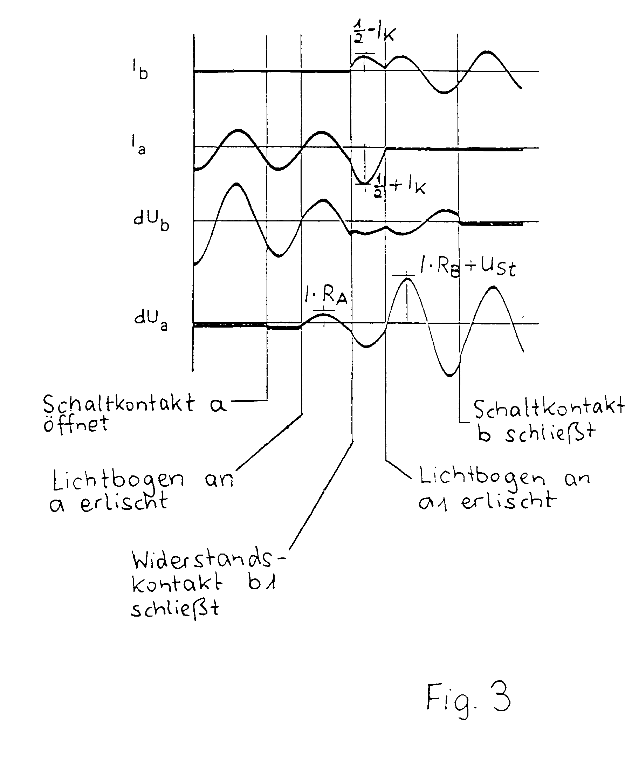

Fig. 3 zeigt das zugehörige Oszillogramm.
Dabei bezeichnet dUa die Spannung über den abschaltenden Schaltstrecken (A,a,a1) und dUb die Spannung über den aufschaltenden Schaltstrecken (B,b,b1), Ia ist der Gesamtstrom der abschaltenden Seite, Ib ist der Gesamtstrom der aufschaltenden Seite.

Aus den beschriebenen Darstellungen sind Lage und Dauer der beiden auftretenden Lichtbögen I und II ersichtlich.

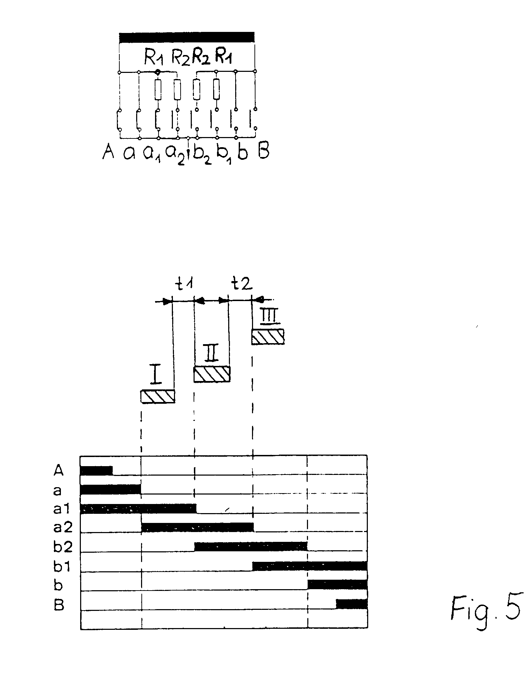

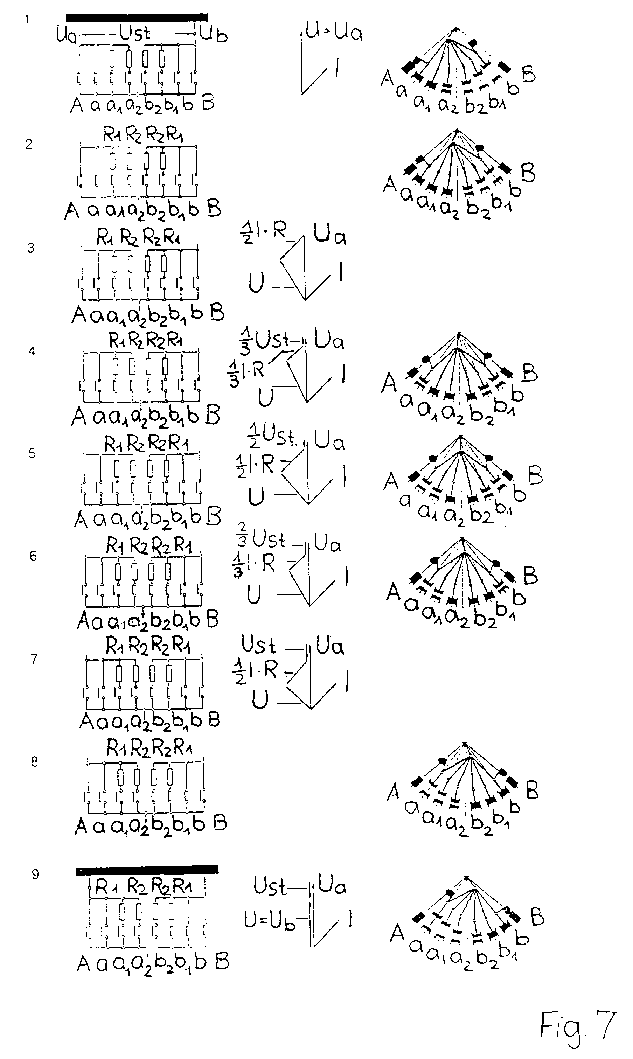

Fig. 5 zeigt eine ebenfalls bekannte Fahnen-Wimpel-Schaltung mit der zugehörigen Schaltsequenz und drei auftretenden Lichtbögen I, II, III; aus der zugehörigen Fig. 7 ist zu erkennen, daß der Lastumschalter dabei bei jeder Umschaltung eine Sequenz von 9 Schaltstellungen durchläuft:
In den Darstellungen bedeuten:
- A,B: Hauptkontakte
- a,b: Schaltkontakte
- a1,b1;a2,b2: Widerstandskontakte
- R1,R2: Überschaltwiderstände
- Ust: Stufenspannung
- U,I: Spannung u. Strom der Stufenschalterableitung.

Eine Lastableitung abwärts läuft wie folgt ab:
Stellung 1: Hauptkontakt A ist geschlossen und führt den Betriebsstrom
Stellung 2: Hauptkontakt A öffnet, Schaltkontakt a übernimmt den Betriebsstrom, Widerstandskontakt a2 schließt
Stellung 3: Schaltkontakt a öffnet, der auftretende Lichtbogen erlischt im ersten Nulldurchgang des Stromes
Stellung 4: der Widerstandskontakt b2 schließt, der Betriebsstrom fließt über die Widerstandskontakte a1, a2 und b2; der jetzt fließende Kreisstrom wird begrenzt durch die parallel geschalteten Widerstände R1 und R2 in Reihe mit Widerstand R2
Stellung 5: der Widerstandskontakt A1 öffnet, der auftretende Lichtbogen erlischt im ersten Nulldurchgang
Stellung 6: der Widerstandskontakt b1 schließt, der Kreisstrom wird jetzt begrenzt durch die Parallelschaltung von R1 und R2 in Reihe mit R2 (s. Stellung 4)
Stellung 7: der Widerstandskontakt a2 öffnet, der Lichtbogen erlischt im ersten Nulldurchgang des Stromes
Stellung 8: der Schaltkontakt a schließt und übernimmt den Betriebsstrom
Stellung 9: der Widerstandskontakt b2 öffnet, der Hauptkontakt B übernimmt den Betriebsstrom; die Lastumschaltung ist beendet.

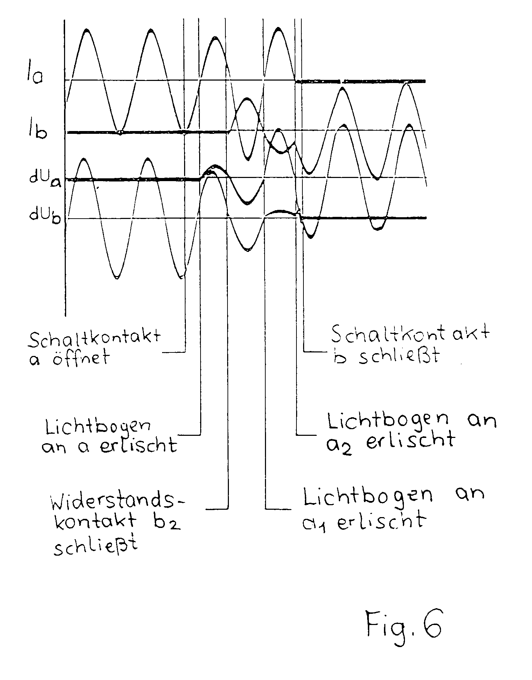

Fig. 6 zeigt wiederum das zugehörige Oszillogramm.

Es ist aus den Darstellungen ersichtlich daß bei dieser Schaltung drei unterschiedliche Lichtbögen I, II, III auftreten, zwischen denen jeweils eine Zeitdauer t1 bzw. t2 liegt.

Aus den dargestellten Abläufen ergibt sich ganz allgemein, daß beim normalen, störungsfreien Schaltablauf eine Zeit t1 zwischen dem Verlöschen des jeweils ersten Lichtbogens I und dem Auftreten des jeweils zweiten Lichtbogens II vorhanden ist und daß, falls mehr als ein Widerstandskontakt auf der abschaltenden Seite vorhanden ist, eine Zeit t2 zwischen dem Verlöschen des zweiten Lichtbogens II und dem Auftreten eines weiteren Lichtbogens III vorhanden ist. Unterschreiten diese Zeiten Mindestwerte oder verschwinden sie ganz, d.h. gehen die einzelnen Lichtbögen zeitlich ineinander über, können unzulässige oder unerwünschte Betriebsbedingungen vorliegen.

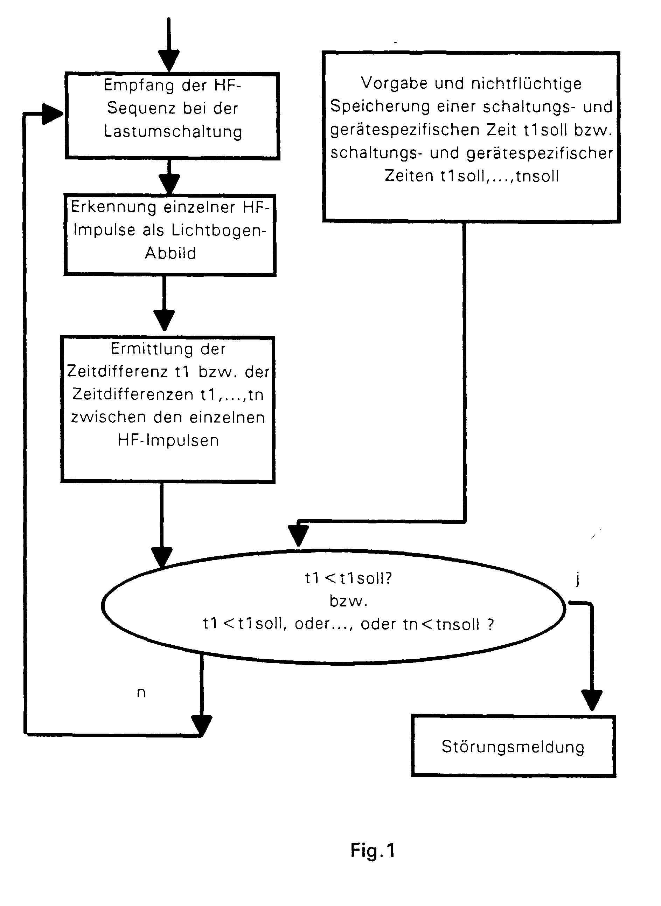

Ist die Lebensdauer von Kontakten überschritten, d.h. deren Kontaktabbrand über ein zulässiges Maß fortgeschritten, unterschreitet t1 bzw t2 einen voreingestellten Mindestwert t1soll bzw. t2soll; dies wird durch das erfindungsgemäße Verfahren erfaßt und als Störung detektiert, wie in Fig. 1 dargestellt.

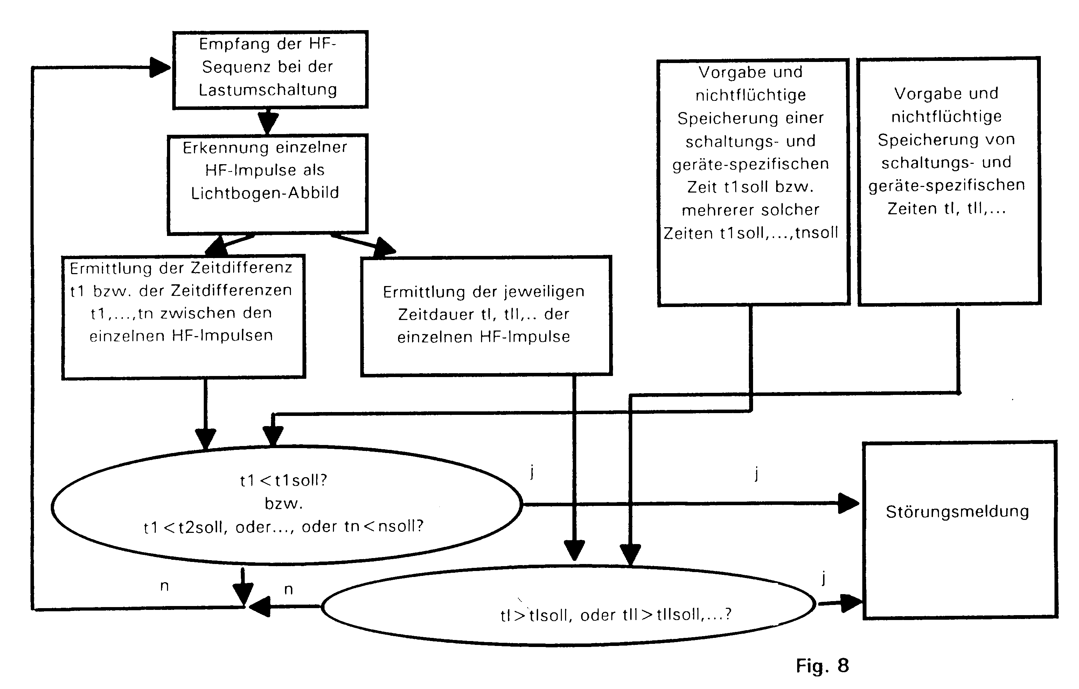

Nach einem in Fig. 8 dargestellten weitergebildeten Verfahren ist es auch möglich, die jeweilige Länge tI bzw. tII des ersten Lichtbogens I bzw. des zweiten Lichtbogens II zu erfassen und ebenfalls mit voreingestellten Sollwerten tIsoll, tIIsoll zu vergleichen.

Es ist auch möglich, die Störungsmeldungen aufzusummieren und erst beim Überschreiten einer vorgegebenen Anzahl eine Meldung nach außen abzugeben.

Besonders vorteilhaft nutzt das erfindungsgemäße Verfahren die von Lichtbögen ausgehenden HF-Strahlungen zur Erfassung und Überwachung des jeweiligen Schaltablaufes. Die Lichtbogenerfassung kann durch bekannte HF-Empfänger außerhalb des Kontaktbereiches, beispielsweise im Stufenschalterkopf erfolgen. Im normalen Betrieb treten die Lichtbögen an den Kontakten jeder Phase annähernd gleichzeitig auf, da die Schaltsequenz bei der Lastumschaltung durch die Zwangssteuerung der Kontakte in allen Phasen synchron erfolgt. Dadurch überdecken sich die jeweiligen Einzellichtbögen in jeder Phase zu einem gemeinsam auswertbaren HF-Signal. Im Fehlerfall führt eine Abweichung in mindestens einer Phase - wie beschrieben - zu einer entsprechend auswertbaren Veränderung der Zeit t und ggf. der Zeiten t1 und t2.

Die Auswerteelektronik zur Durchführung des Verfahrens, die vorzugsweise aus einem Mikrorechner mit einer CPU besteht, kann im jeweiligen Motorantrieb des Stufenschalters angeordnet sein; das Verfahren kann jedoch auch in einem zugeordneten elektronischen Spannungsregler realisiert werden.

In den bisher erläuterten Ausführungsbeispielen ist von einer Erkennung der Lichtbögen durch Empfang der von ihnen generierten HF-Signale ausgegangen und das Verfahren unter Zugrundelegung einer solchen Erkennung beschrieben worden.
Es ist natürlich auch möglich, beim erfindungsgemäßen Verfahren andere von Lichtbögen ausgehende physikalische Effekte zur Erfassung und Überwachung des jeweiligen Schaltablaufes zu nutzen.
Beispielsweise kann die Erfassung der Lichtbögen durch direkte optische Lichtbogenerkennung, mit Lichtleiter etwa, erfolgen.
Es ist auch möglich, die von Lichtbögen ausgehenden Druckwellen oder akustischen Signale zu detektieren und zur Lichtbogenerkennung heranzuziehen.
Letztendlich bleibt es dem Anwender überlassen, welchen vom Lichtbogen erzeugten physikalischen Effekt er zu dessen Erkennung heranziehen will - eine solche Entscheidung ist u.a. von der Bauart des entsprechenden Stufenschalters, dem benutzten Isoliermedium, der vorhandenen Hard- und Software zur Auswertung sowie Genauigkeits- und Kostenanforderungen abhängig.
Die Wahl des physikalischen Effektes zur Lichtbogenerkennung beeinflußt die Funktionsfähigkeit des erfindungsgemäßen Verfahrens im übrigen auch nicht. Unabhängig von der gewählten Meß- bzw. Erfassungsart ist es auf auf jeden Fall möglich, aus der gemessenen Sequenz einzelne Meßgrößenimpulse als jeweiliges Lichtbogenabbild zu erkennen und mit diesem die erfindungsgemäßen Verfahrensschritte durchzuführen.

## Patentansprüche

1. Verfahren zur Überwachung eines Lastumschalters für einen Stufenschalter, wobei der Lastumschalter feststehende Haupt- und Hilfskontakte und mit diesen korrespondierende bewegliche Haupt- und Hilfskontakte aufweist, die sich nacheinander auf den jeweiligen feststehenden Kontakten abwälzen, auf diesen abrollen oder dgl., derart, daß eine definierte Schaltsequenz realisiert wird,
dadurch gekennzeichnet,
daß während der eigentlichen Lastumschaltung eine vom Lastumschalter ausgehende, durch Lichtbogen erzeugte physikalische Größe als Meßgröße empfangen wird,
daß aus der empfangenen Meßgröße einzelne Impulse als Lichtbogenabbild erkannt werden, daß die Zeit t1 bzw. die Zeiten t1,..,tn zwischen den Impulsen der empfangenen Meßgröße erfaßt wird bzw. erfaßt werden,
daß nachfolgend die Zeit t1 bzw. jede der Zeiten t1,...,tn mit einer zugeordneten voreingestellten und nicht flüchtig gespeicherten schaltungs- und gerätespezifischen Zeit t1soll bzw. t1soll,...,tnsoll verglichen wird bzw. werden,
und daß, wenn die Zeit t1 kleiner als die voreingestellte Zeit t1soll ist bzw. eine der Zeiten t1,...,tn kleiner als die jeweils zugehörige voreingestellte Zeit t1soll,...,tnsoll ist, nachfolgend eine Störungsmeldung erzeugt wird.

2. Verfahren nach Anspruch 1,
dadurch gekennzeichnet,
daß zusätzlich die Zeitdauer tI, tII,... jedes Impulses erfaßt wird, daß nachfolgend jede der Zeiten tI, tII,... mit einer zugehörigen voreingestellten und nicht flüchtig gespeicherten schaltungs- und gerätespezifischen Zeit tIsoll, tIIsoll,... verglichen wird,
und daß, wenn eine der erfaßten Zeiten tI, tII,... größer ist als eine der zugehörigen voreingestellten Zeiten tIsoll, tIIsoll,... ist, nachfolgend ebenfalls eine Störungsmeldung erzeugt wird.

3. Verfahren nach Anspruch 1 oder 2,
dadurch gekennzeichnet,
daß als Meßgröße die vom Lichtbogen ausgehenden HF-Signale erfaßt werden.

4. Verfahren nach Anspruch 1 oder 2,
dadurch gekennzeichnet,
daß als Meßgröße die vom Lichtbogen ausgehende Helligkeit erfaßt wird.

5. Verfahren nach Anspruch 1 oder 2,
dadurch gekennzeichnet,
daß als Meßgröße die vom Lichtbogen ausgehenden Druckwellen erfaßt werden.

6. Verfahren nach Anspruch 1 oder 2,
dadurch gekennzeichnet,
daß als Meßgröße die vom Lichtbogen ausgehenden akustischen Signale erfaßt werden.

## Claims

1. Method of monitoring a load changeover switch for a tap selector, wherein the load changeover switch comprises stationary and main and auxiliary contacts and movable main and auxiliary contacts which correspond therewith and which one after the other roll along the respective stationary contacts, run on these or the like in such a manner that a defined switching sequence is realised, characterised in that during the actual load changeover a physical magnitude, which is derived from the load changeover switch and produced by an arc, is picked up as a measurement magnitude, that individual pulses as an arc image are recognised from the picked-up measurement magnitude, that the time t1 or the times t1 to tn between the pulses of the picked-up measurement magnitude is or are detected, that subsequently the time t1 or each of the times t1 to tn is compared with an associated predetermined time t1soll or t1soll to tnsoll, which is stored in non-volatile manner and specific to the switching process and apparatus, and that if the time t1 is less than the predetermined time t1soll or one of the times t1 to tn is less than the respectively associated predetermined time t1soll to tnsoll a disturbance report is subsequently produced.

2. Method according to claim 1, characterised in that in addition the time period tl, tll, ... of each pulse is detected, that subsequently each of the times tl, tll, ... is compared with an associated predetermined time tlsoll, tllsoll, ... which is stored in non-volatile manner and specific to the switching process and apparatus, and that if one of the detected times tl, tll, ... is greater than one of the associated predetermined times tlsoll, tllsoll, ..., a disturbance report is subsequently produced.

3. Method according to claim 1 or 2, characterised in that the HF signals derived from the arc are detected as measurement magnitude.

4. Method according to claim 1 or 2, characterised in that the brightness derived from the arc is detected as measurement magnitude.

5. Method according to claim 1 or 2, characterised in that the pressure waves derived from the arc are detected as measurement magnitude.

6. Method according to claim 1 or 2, characterised in that the acoustic signals derived from the arc are detected as measurement magnitude.

## Revendications

1. Procédé de surveillance d'un commutateur en charge d'un sélecteur d'échelon selon lequel le commutateur en charge comporte des contacts principaux et des contacts auxiliaires fixes ainsi que des contacts principaux et auxiliaires mobiles correspondants, qui roulent sur les contacts fixes respectifs, successivement ou roulent sur ceux-ci de manière à réaliser une séquence de commutation déterminée,
caractérisé en ce que
pendant la commutation en charge proprement dite, on reçoit comme grandeur de mesure une grandeur physique créée par l'arc électrique dans le commutateur en charge,
- à partir de la grandeur de mesure, reçue, on reconnaît différentes impulsions comme image de l'arc électrique,
- on saisit le temps t1 ou les temps t1...tn, entre les impulsions de la grandeur de mesure reçue,
- puis, on compare les temps t1 ou chacun des temps t1...tn à une durée t1cons, t1cons...tncons, associée, préréglée, spécifique au circuit et à l'appareil et enregistrée en mémoire d'une manière non volatile, et
- si la durée t1 est inférieure à la durée préréglée t1cons, ou si l'une des durées tl...tn est inférieure à la durée préréglée correspondante t1cons...tncons, on génère un signal d'incident.

2. Procédé selon la revendication 1,
caractérisé en ce qu'
en plus on détecte la durée tI, tII de chaque impulsion,
- puis, on compare chacune des durées tI, tII... a une durée tIcons, tIIcons..., préréglée de façon correspondante et enregistrée dans la mémoire non volatile, de façon spécifique au circuit et à l'appareil, et
- si l'une des durées saisies tI, tII..., est supérieure à l'une des durées préréglées tIcons, tIIcons..., on génère également ensuite un signal d'incident.

3. Procédé selon la revendication 1 ou 2,
caractérisé en ce que
comme grandeur de mesure, on détecte les signaux HF émis par l'arc électrique.

4. Procédé selon la revendication 1 ou 2,
caractérisé en ce que
comme grandeur de mesure, on détecte la luminosité de l'arc électrique.

5. Procédé selon la revendication 1 ou 2,
caractérisé en ce que
comme grandeur de mesure, on détecte les ondes de pression émises par l'arc électrique.

6. Procédé selon la revendication 1 ou 2,
caractérisé en ce que
comme grandeur de mesure, on détecte les signaux acoustiques émis par l'arc électrique.
